# EUROPEAN PATENT APPLICATION

(11) **EP 1 975 125 A1**
(43) Date of publication of application: **01.10.2008**
(21) Application number: 06841755.9
(22) Date of filing: 22.12.2006
(51) Int. Cl.: C01F 7/42, C01F 7/02

(54) **METHOD FOR OBTAINING ALPHA-ALUMINA CRYSTALS OR FIBRES USING THE VAPOUR-LIQUID-SOLID (VLS) MECHANISM, BY CONTROLLING THE SLIGHTLY-OXIDISING ATMOSPHERES IN SYSTEMS THAT CONTAIN METAL AL AND SIO2**

(30) Priority: 26.12.2005 ES 200600044 U
(71) Applicant: UNIVERSIDADE DE SANTIAGO DE COMPOSTELA, 15782 Santiago de Compostela (ES)
(72) Inventor: CERECEDO FERNÁNDEZ, Carmen, 15782 Santiago de Compostela (ES); VALCÁRCEL JUÁREZ, Víctor Andrés, 15782 Santiago de Compostela (ES); GUITIÁN RIVERA, Francisco, 15782 Santiago de Compostela (ES)
(74) Representative: Carvajal y Urquijo, Isabel
(86) International application number: PCT/ES2006/000703
(87) International publication number: WO 2007/074192

(57) **Abstract**

The invention relates to a method for obtaining α-alumina crystals or fibers using the vapor-liquid-solid (VLS) mechanism, by controlling the slightly oxidizing atmospheres in systems that contain metal Al and SiO₂. The inventive method consists of growing α-alumina fibers using the growth of alumina fibers via VLS from Al and SiO₂, and controlling the partial pressure of the different oxidizing agents, in the area known as active oxidation of Al with formation of corundum fume and active oxidation of Si with formation of silica fume in accordance with the respective Si-SiO₂ and Al-Al₂O₃ volatility diagrams.

## Description

Corundum or α-alumina is a relatively scarce mineral appearing in generally metamorphic type aluminous rocks, such as marble, micaceous schist and gneiss, although it can occasionally be related to igneous rocks.

Due to its physical properties, and especially its chemical, electrical and thermal properties, corundum is used in many applications. For example, as a catalytic support, heat insulation, in refractories, advanced ceramics, etc.

The particular characteristics of alumina have made this material one of the main dispersed phases, used in the form of fibers, in many different industrial type applications. Fibers with a high percentage of alumina and the absence of glassy phases are very chemically stable and are manufactured for their use in composites and in refractories where high temperatures are required (T. F. Cooke, "Inorganic Fibers, A Literature Review", J. Am. Ceram. Soc., 74 [12] 2959-78, (1991)). It is therefore very interesting to provide novel methods for generating corundum and producing novel morphologies of this oxide.

Spanish patent ES2146506 describes a method for obtaining crystalline alumina fibers using vapor-liquid-solid (VLS) deposition from silica and metal aluminium in inert atmospheres. See also "Obtención de fibras de α-Al2O3 por VLS para su utilización en composites". V. Valcárcel. Thesis publication in CD-ROM. ISBN: 84-8121-750-6; "Novel Ribbon Shaped α-Al2O3 Fibers", V. Valcárcel, A. Pérez, M. Cyrklaff and F. Guitián. Advanced Materials 10, No. 16, (1370-1373), 1998. (Cover Item); "Development of Single Crystal α-Al2O3 Fibers by Vapour-Liquid-Solid Deposition (VLS) from Aluminium and Powdered Silica" V. Valcárcel, A. Souto, and F. Guitián. Advanced Materials, 10, no. 2, pg. 138-140, (1998).

Patent ES2182684 describes a method for obtaining alumina single-crystal fibers using the VLS method described in the aforementioned patent ES2146506, but in this case the innovation consists of the use of atmospheres containing metal gases. "Method for Production of Alpha-Alumina Whiskers via Vapor-Liquid-Solid Deposition". V. Valcárcel, C. Cerecedo, F. Guitián, J. Am. Ceram. Soc. 86 [10] 1683-90 (2003). According to this method, the aluminium which evaporates reacts with silica and the VLS mechanism starts, producing Si(I), Si(g), SiO(g) and Al₂O(g). The use of metals such as Ni allows working at high temperatures, this liquid metal being maintained in the range of interest. Once liquid drops of the metal in question have been generated, the gaseous species are dissolved in them and react, giving alumina in the form of fiber precipitated due to oversaturation, a considerably increase in the production of alumina single-crystal fibers being achieved.

Other methods of interest in which Al is also used for obtaining corundum fibers take place in a H₂O vapor and H₂ atmosphere. "Method of Growing Alpha-Alumina Single Crystal Ribbons", 1104715 published: Feb. 28, (1968). The gas stream is passed through a crucible containing molten Al, incorporating H₂O. The reactions with H₂ and H₂O vapor allow producing alumina single-crystal ribbons. Patent US 3,514,256, consists of passing a H₂ stream through two crucibles, one containing molten Al and the other one an inorganic compound containing Si-O bonds. Corundum crystals with different shapes: fibers, ribbons, filaments, etc. are thus formed. The H₂ used can be added directly or generated *in situ* through the reaction of H₂O(g) contained by the argon gas stream with the Al which is evaporating.

A very useful tool which is commonly used for studying different chemical systems are volatility diagrams. For example, the Si-SiO₂ and Al-Al₂O₃ systems have been much studied. "Volatility Diagrams for Silica, Silicon Nitride, and Silicon Carbide and their Application to High-Temperature Decomposition and Oxidation"; Arthur H. Heder, Victor L. K. Lou. J. Am. Ceram. Soc., 73 [10] 2785-3128 (1990). "Graphical Displays of the Thermodynamics of High-Temperature Gas-Solid Reactions and Their Application to Oxidation of Metals and Evaporation of Oxides"; V. L. K. Lou, T.E. Mitchell and A.H.Heuer. J. Am. Ceram. Soc., 68 [2] 49-58 (1985).

In the present invention patent proposal, a novel method has been developed which achieves the production of α-Al₂O₃ fibers using the VLS (Vapor-Liquid-Solid) mechanism in atmospheres in which a precise control of the oxidizing agents has been carried out, depending on the Si-SiO₂ and Al-Al₂O₃ volatility diagrams, respectively. The novelty consists of growing alumina fibers controlling the partial pressure of the different oxidizing agents, using the growth of α-Al₂O₃ via VLS from aluminium and silica.

Through theoretical calculations, taking into account the respective volatility diagrams, the necessary modifications are made in order to be located in the area known as "active oxidation of silica with formation of silica fume" and in the area of "active oxidation of aluminium with formation of corundum fume" of the respective diagrams. This mechanism, together with VLS, gives rise to the massive production of corundum crystals or fibers. These fibers have a particular morphology, as they are formed by a lattice of α-alumina fibers mixed by a continuous layer of mullite, silicon and cristobalite. A strong increase of the production of α-Al₂O₃ crystals is achieved with the method, which makes this development highly interesting. The formation of silicone, mullite and cristobalite is a drawback which can be easily eliminated by means of the selective action of mixtures of acids.

### Method

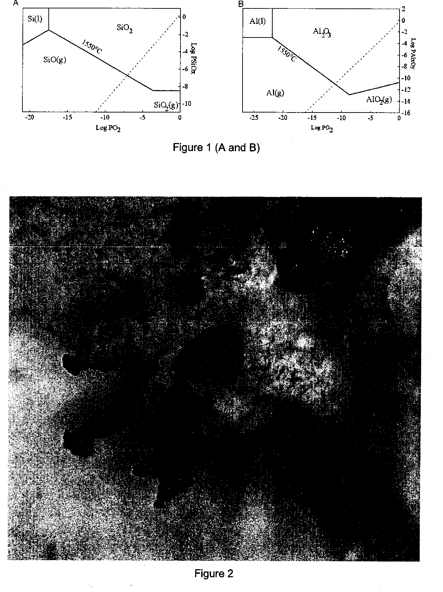

The proposed method is based on controlling the partial pressures of the oxidizing agent using the volatility diagrams of Figure 1: Si-SiO₂ (Figure 1a) and Al-Al₂O₃ (Figure 1b) volatility diagrams at 1550°C, showing the maximum partial pressure lines at equilibrium of the different phases in the system for this temperature.

Any system can be used to control this partial pressure, for example, passing argon through a vessel containing ice, through mixtures of gases containing oxidants in controlled proportions, by means of placing sponges or other porous materials containing the adsorbed oxidizing agent in the oven or by means of generating *in situ* compounds with an oxidizing character.

Considering the respective volatility diagrams, for example at 1550°C (Figure 1), if the partial pressure of the oxidizing agent is managed to be maintained in the range of pressures <10⁻³atm up to 10⁻¹¹atm, Al stops being in equilibrium with Al₂O₃ and the reaction mechanism is called active oxidation with formation of corundum fume. In the same way, below those pressures up to 10⁻⁷atm, SiO(g) reaches equilibrium with SiO₂; the active oxidation of Si with formation of silica fume taking place.

If the VLS mechanism without the intervention of any oxidizing agent is considered as the starting point, aluminium reacts with silica and the VLS mechanism starts, producing silicon and the main gaseous species for the formation of Al₂O and SiO fibers. According to this mechanism, drops are generated and the gaseous species dissolve in them and react, giving alumina precipitated due to oversaturation.

In the event that the atmosphere has an oxidizing character, for example argon with water vapor, if its control is maintained, alumina fibers or crystals can be grown in special conditions, which allows a complete control of the VLS process. Water is a strong oxidizing agent reacting with the main gaseous species Al₂O(g) and SiO(g), alumina and silica precipitating. According to the volatility diagrams of Figure 1, at 1550°C and in oxidizing atmospheres with oxygen partial pressures greater than 10' ³atm, the passivation of aluminium occurs and therefore the VLS mechanism does not take place. A method is set forth in the present invention patent in which the oxidizing atmosphere can be controlled: for example, argon with water vapor, maintaining the partial pressure below 10⁻³atm at all times. According to the Al-Al₂O₃ volatility diagram, if the water vapor partial pressures are maintained within the ranges from 10⁻¹¹ up to 10⁻³ atm, aluminium undergoes an active oxidation with formation of corundum fume. In the case of silicon, the active oxidation with formation of silica fume takes place in the range comprised between 10⁻**⁷** and 10⁻³atm. Therefore, in this method, unlike any other previous method, the oxidizing atmosphere is controlled and maintained in these ranges. This mechanism, together with the VLS mechanism, gives rise to the formation of alumina fibers in large amounts. These fibers are linked to one another by a glass formed by mullite and silica which can be easily eliminated by the action of acids, such as mixtures of HNO₃ and HF for example, the alumina fibers remaining intact.

Figure 2 shows an image of the corundum crystals obtained, formed by a lattice of white alumina fibers and a black area containing a continuous layer formed by mullite, silicon and silica. The crystals therefore have a particular morphology that has not been described previously.

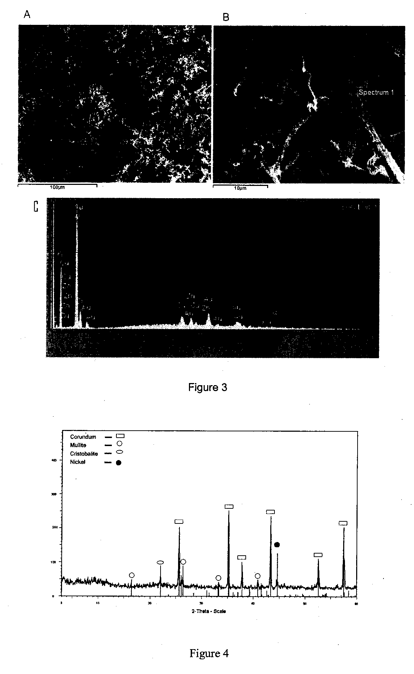

Figure 3 shows, A) Micrograph of a group of fibers. B) Detail of the fibers obtained. C) EDS analysis of the fibers. It has been verified through EDS (Energy Dispersive Spectroscopy) that the fibers are mainly formed by Al and O, although some Si appearing in the area of the tips of the fibers is also observed. Alumina fibers interlinked and covered by a continuous layer the composition of which is Si, SiO₂ and mullite, the amount of each varying between different measurements made, can be microscopically observed.

These results coincide with the XRD (X-ray diffraction) analysis of Figure 4, showing the XRD of the fibers and the layer joining them. The predominant crystalline phase corresponds to α-Al₂O₃, although cristobalite and mullite are also formed.

It must be emphasized that the invention patent proposal differs from all the methods existing in the literature for several reasons:
- In this case, the growth mechanism is VLS and not vapor-solid (VS) deposition,
- Slightly oxidizing atmospheres are used, controlling the partial pressure of the oxidizing agent by means of the volatility diagrams, unlike other methods which use H₂O vapor partial pressures above 10⁻³atm.
- At the same time as the α-Al₂O₃ fibers grow, other by-products such as silicon, mullite and cristobalite are obtained with this method.

Therefore, the novelty is the control of the oxidizing atmosphere in the VLS process, allowing it to take place without passivating aluminium, and maintaining the partial pressures in the range of active oxidation of aluminium with formation of corundum fume, and active oxidation of silicon with formation of silica fume; i.e., partial pressure of the oxidizing agent <10⁻³atm.

### Example 1

The oven used for obtaining the fibers is a controlled-atmosphere oven of the type called "cold-wall" oven, the chamber of which has (30*35*40) cm dimensions and is completely coated with an alumina ceramic fiber insulator. This oven allows working in conditions of vacuum, inert atmospheres, oxidizing atmospheres, etc. In this case, the controlled atmospheres is an argon gas atmosphere that is slightly oxidizing due to the incorporation of small amounts of water, although other noble gases, such as helium for example, and other oxidants such as oxygen can also be used.

A completely homogeneous mixture of powdered silica having a size <63µm with 10% of also powdered Ni having a particle size <63µm is placed in a (25*25*1.5) cm aluminium tray. Several pieces of aluminium with a diameter of 4 mm and a length of 1 cm are placed half-buried on the mixture.

The sample is introduced inside the oven. This oven is connected to an argon gas source the flow of which is 80 l/h. A vessel with ice the equilibrium vapor pressure of which at 0°C is approximately 10⁻³atm is placed between the oven and the gas source.

The working conditions are the following: a heating ramp at 10°C/min, 3 hours remaining at 1550°C and a cooling ramp of 10°C/min. The argon flow is maintained constant during the plateau and heating ramp.

The result obtained is a tray coated with corundum crystals or fibers, with a production between 10 and 100 grams.

Once the fibers are obtained, they are introduced in a resistant vessel with mixtures of acids, such as concentrated HNO₃ and HF for example, to eliminate the layer of mullite and silica linking them, the corundum fibers remaining intact.

The fibers are analyzed by means of DRX and SEM. Figure 4 shows the diffractogram, in which the peaks corresponding to alumina and in a smaller proportion, mullite and cristobalite can be mainly seen. These results coincide with the EDS analysis of Figure 3, in which mostly Al and O appear.

## Claims

1. A method for obtaining α-alumina crystals or fibers using the VLS mechanism, by controlling the slightly oxidizing atmospheres in systems that contain Al metal and SiO₂, wherein the slightly oxidizing atmospheres are designed depending on the Al-Al₂O₃ and Si-SiO₂ volatility diagrams, in the area of active oxidation of aluminium with formation of corundum fume and active oxidation of silicon with formation of silica fume.

2. The method according to claim 1, **characterized in that** the oxidizing atmospheres are obtained by passing pure argon gas on ice at 0°C to achieve partial pressures below 10⁻³atm, and circulating this gaseous mixture on the reactants.

3. The method according to the previous claims, whereby a massive deposition of interlinked crystalline α-alumina fibers with diameters of 0.1-10 µm and lengths of more than 1 mm is obtained, with the simultaneous formation of several by-products such as silicon, mullite and cristobalite.

4. The method according to claim 3, whereby these by-products can be eliminated by 3:2 mixtures of 63% HNO₃ and 40% HF.

5. The method according to claims 1, 2 and 3, **characterized in that** the fibers produced can be used in composites.
